# EUROPEAN PATENT APPLICATION

(11) **EP 1 933 370 A2**
(43) Date of publication of application: **18.06.2008**
(21) Application number: 07024237.5
(22) Date of filing: 13.12.2007
(51) Int. Cl.: H01L 21/00

(54) **Method and apparatus for heating a substrate**

(30) Priority: 15.12.2006 US 611704
(71) Applicant: Applied Materials, Inc., Santa Clara, CA 95054 (US)
(72) Inventor: Ranish, Joseph, M., San Jose, CA 95117 (US); Adams, Bruce, E., Portland, OR 97239 (US); Hunter, Aaron, M., Santa Cruz, CA 95060 (US)
(74) Representative: Zimmermann, Gerd Heinrich

(57) **Abstract**

A method and apparatus for heating a substrate is provided herein. In one embodiment, a substrate heater 108 includes a vessel 200 having an upper member 204 including a top surface for supporting a substrate 106 thereon; a liquid 210 disposed within and partially filling the vessel; and a heat source 208 for providing sufficient heat to the liquid to boil the liquid. Optionally, a pressure controller for regulating the pressure within the vessel may be provided. The substrate is heated by first placing the substrate on the support surface of the vessel of the substrate heater. The liquid contained in the vessel is then boiled. As the liquid is boiling, a uniform film of heated condensation is deposited on a bottom side of the support surface. The heated condensation heats the support surface which in turn, heats the substrate.

## Description

Embodiments of the present invention generally relate to a method and apparatus for heating a substrate. More specifically, aspects of the present invention relate to heating a substrate using a simultaneous presence of liquid and gas on the underside of a heat transfer solid to establish a controlled temperature buffer zone. Aspects of the invention also relate to a substrate heater and to a system for heating a substrate. Particular aspects relate to a substrate heater and a heating system each having a vessel, a fluid or liquid disposed within the vessel; and a heat source for providing heat to the fluid or liquid.

In semiconductor substrate processing, the surface temperature of the substrate is often a critical process parameter. Changes in, and gradients across the substrate surface during substrate processing are detrimental to material deposition, etch rate, feature taper angles, step coverage, and the like. It is often desirable to have control over a substrate temperature profile before, during, and after substrate processing to enhance processing and minimize undesirable characteristics and/or defects.

A number of devices have been used in the art to control substrate temperature during processing. One method feeds a chilled fluid through a substrate support pedestal during substrate processing. The fluid removes heat from the substrate support pedestal thus cooling the substrate. This method of cooling the substrate has two inherent problems. First, the response time required to bring a substrate to a desired temperature is relatively long. As such, rapid dynamic control of the fluid temperature to compensate for rapid substrate temperature fluctuations is not possible. Consequently, the substrate is not maintained at a desired temperature.

A second disadvantage of this method is the inability to control the temperature profile across the surface of the substrate, particularly where a uniform temperature profile is desired. Heat transfer from the substrate to the substrate support pedestal is generally greatest in the center of the substrate and less towards the edges. Since the fluid temperature is generally uniform inside the substrate support pedestal, the substrate cools more rapidly in the center. This causes a temperature gradient across the substrate surface, becoming more severe with increased diameter substrates, e.g., 300 mm substrates. This temperature gradient is one of the primary causes of feature variation in semiconductor substrate processing.

Another method of controlling substrate temperature that provides rapid dynamic control of the pedestal temperature uses thermo-electric devices embedded in the pedestal surface that supports the substrate (i.e., the support surface). These devices are oriented in a planar array below the support surface of the pedestal. However, within such an array, temperature gradients form between the individual devices, i.e., each device effectively transfers heat at its location while a lesser amount of heat is transferred at the locations immediately adjacent to and between the devices. Such gradients between a plurality of devices cause substantial temperature variation across the substrate, i.e., hot and cold locations are formed. Consequently, process variations may occur across the substrate in response to the temperature variations.

Additionally, the high bias power (up to and exceeding 1000 Watts) applied to electrostatic chucks used in etching some materials contribute significantly to the heat load upon the substrate, requiring further cooling of the substrate. Additionally, processing temperatures used in etching certain materials require temperatures in the range of 200°C to 400°C or higher. Such high processing temperatures require a pedestal that can quickly bring a substrate up to and maintain predetermined processing temperatures.

Therefore, there is a need in the art for an apparatus for controlling and maintaining the temperature of a substrate.

In view of the above, a substrate heater according to claim 1, and a system for heating a substrate according to claim 15 are provided. Thereby, a method and apparatus for heating a substrate is provided. Further advantages, features, aspects and details of the invention are evident from the dependent claims, the description and the drawings.

In one embodiment, a substrate heater includes a vessel having an upper member including a top surface for supporting a substrate thereon; a liquid disposed within and partially filling the vessel; and a heat source for providing sufficient heat to the liquid to boil the liquid. Optionally, a pressure controller for regulating the pressure within the vessel may be provided. The substrate may be heated by first placing the substrate on the support surface of the vessel of the substrate heater. The liquid contained in the vessel may then be boiled. As the liquid is boiling, a uniform film of heated condensation may be deposited on a bottom side of the support surface. The heated condensation heats the support surface which in turn, heats the substrate.

In another embodiment, a system for heating a substrate includes a vessel having a support surface for supporting a substrate thereon; a fluid disposed within the vessel at a temperature below its critical point; an energy phase controller for controlling the energy phase of the fluid disposed within the vessel; and a controlled temperature buffer zone for conducting heat through the vessel to the support surface, the controlled temperature buffer zone partially defined by an inner surface of the support surface facing an interior of the vessel, wherein, the fluid changes energy phase upon entering and leaving the controlled temperature buffer zone.

In another aspect of the invention, a method for heating a substrate is provided. In one embodiment, a method of heating a substrate includes placing a substrate on a support member of a substrate heater comprising a vessel partially filled with a liquid; and boiling the liquid to create a film of condensation on a bottom side of the support member. Optionally, the pressure inside the vessel may be controlled. Optionally, the energy phase of the liquid disposed within the vessel may be controlled.

The invention is also directed to apparatuses for carrying out the disclosed methods and including apparatus parts for performing each described method steps. These method steps may be performed by way of hardware components, a computer programmed by appropriate software, by any combination of the two or in any other manner. Furthermore, the invention is also directed to methods by which the described apparatus operates. It includes method steps for carrying out every function of the apparatus or manufacturing every part of the apparatus.

The teachings of the present invention will become apparent by considering the following detailed description in conjunction with the accompanying drawings, in which:

Figure 1 depicts a schematic, cross-sectional view of a semiconductor substrate process chamber having an apparatus for heating a substrate in accordance with one embodiment of the present invention

Figure 2 depicts a schematic, cross-sectional view of one embodiment of the apparatus for heating a substrate depicted in Figure 1; and

Figure 3 depicts a flowchart of a method for heating a substrate in accordance with one embodiment of the present invention.

Where possible, identical reference numerals are used herein to designate identical elements that are common to the figures. The images in the drawings are simplified for illustrative purposes and are not depicted to scale.

The appended drawings illustrate exemplary embodiments of the invention and, as such, should not be considered as limiting the scope of the invention, which may admit to other equally effective embodiments.

The present invention provides a method and apparatus for heating a substrate utilizing a simultaneous presence of liquid and gas on the underside of a heat transfer solid to establish a controlled temperature buffer zone. The heating apparatus employs a vessel containing a liquid which, when boiling, creates a substantially uniform film of condensation on the bottom of a substrate support surface. The film of condensation is heated by the condensation of the vapor phase, thereby heating the substrate support surface, and a substrate disposed thereon. Evaporation of portions of the film of condensation removes heat from the film of condensation, thereby facilitating the maintenance of a substantially uniform temperature of the condensate, and ultimately, the substrate. The exchange of heat which occurs during the phase change of the fluid on the support underside occurs at a constant temperature, that of the vapor-liquid equilibrium temperature for the fluid. In embodiments where the fluid vapor is maintained at atmospheric pressure, that temperature is the normal boiling point for the fluid.

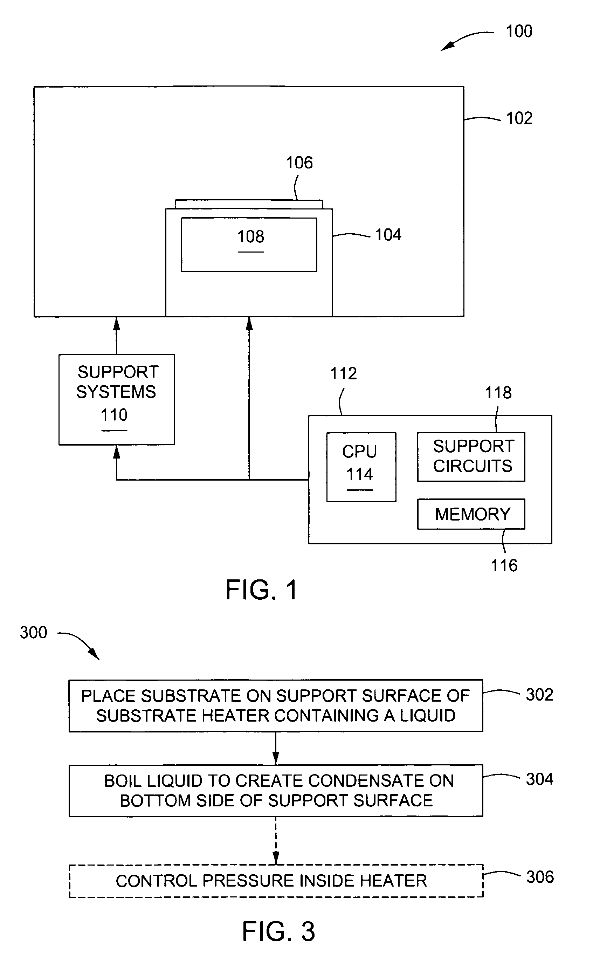

Figure 1 is a schematic cross-sectional view of a process chamber 100 in accordance with one embodiment of the present invention. The process chamber 100 is suitable for fabricating and/or treating thin films on a substrate 106 where it is desirable to heat the substrate. For example, the process chamber 100 may be adapted to perform at least one of deposition processes, etch processes, plasmaenhanced deposition and/or etch processes, and thermal processes (such as rapid thermal processes (RTP), annealing, and the like) among other processes performed in the manufacture of integrated semiconductor devices and circuits. The substrate 106 may be any substrate, such as semiconductor wafers, glass or sapphire substrates, or the like.

The process chamber 100 illustratively comprises a chamber body 102, support systems 110, and a controller 112. A substrate support pedestal 104 is disposed within the chamber body 102 for supporting a substrate 106 thereon. The pedestal 104 generally comprises a substrate heater 108 disposed therein and configured to control the temperature of the substrate 106 during processing.

The support systems 110 of the process chamber 100 include components used to execute and monitor pre-determined processes (e.g., depositing, etching, thermal processing, and the like) in the process chamber 100. Such components generally include various sub-systems (e.g., gas panel(s), gas distribution conduits, vacuum and exhaust sub-systems, and the like) and devices (e.g., power supplies, process control instruments, and the like) of the process chamber 100. These components are well known to those skilled in the art and are omitted from the drawings for clarity.

The controller 112 generally comprises a central processing unit (CPU) 114, a memory 116, and support circuits 118 and is coupled to and controls the process chamber 100, substrate heater 108, and support systems 110, directly (as shown in Figure 1) or, alternatively, via computers associated with the process chamber 100, substrate heater 108, and/or the support systems 110. The controller 112 may be one of any form of general-purpose computer processor that can be used in an industrial setting for controlling various chambers and sub-processors. The memory, or computer-readable medium, 116 of the CPU 114 may be one or more of readily available memory such as random access memory (RAM), read only memory (ROM), floppy disk, hard disk, or any other form of digital storage, local or remote. The support circuits 118 are coupled to the CPU 114 for supporting the processor in a conventional manner. These circuits include cache, power supplies, clock circuits, input/output circuitry and subsystems, and the like. Inventive methods of heating the substrate, or portions thereof, are generally stored in the memory 116 as a software routine. The software routine may also be stored and/or executed by a second CPU (not shown) that is remotely located from the hardware being controlled by the CPU 114.

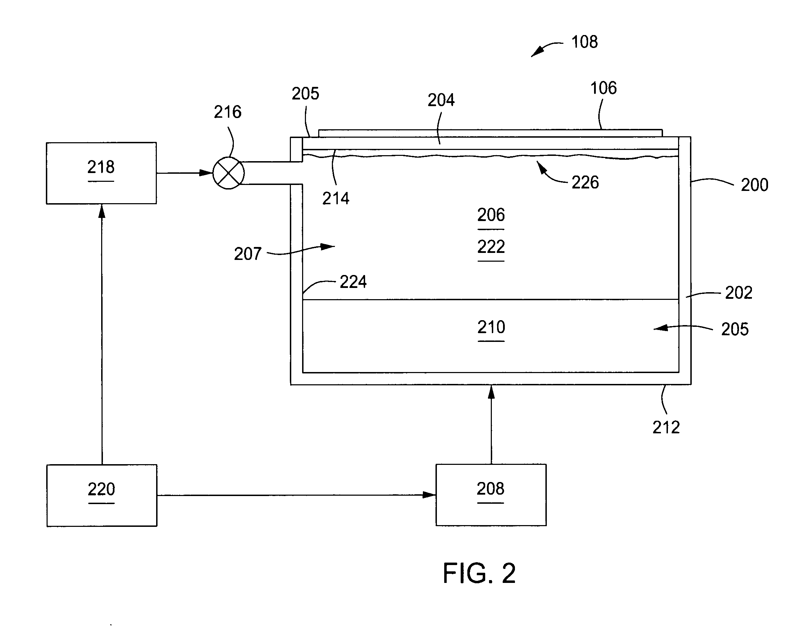

Figure 2 depicts one embodiment of the substrate heater 108. In the embodiment depicted in Figure 2, the substrate heater 108 comprises a vessel 200 having a liquid 210 disposed in a bottom portion thereof and a heat source 208 for providing sufficient heat to boil the liquid 210 during operation. The vessel 200 includes a body 202 having an upper member 204 and defining an interior volume 206 therein. The vessel 200 may generally be any size or shape such that the upper member 204 is of sufficient size to support a substrate (e.g., substrate 106) thereupon (e.g. on a top surface thereof). In one embodiment, the vessel 200 is cylindrical. The body 202 and the upper member 204 of the vessel 200 may be fabricated of any material or combination of materials suitable for withstanding the processing environment and conditions during operation (such as resistance to corrosive materials, elevated temperatures and pressures, and the like). Examples of suitable materials include metals (such as copper, aluminum, and the like), metal alloys, ceramics, and the like.

The interior volume 206 of the vessel 200 includes an upper portion 207 and a lower portion 205. The upper portion 207 of the interior volume is generally equal to or greater than the size of the substrate 106 to be heated. The lower portion 205 of the interior volume 206 may be less than, equal to, or larger than the upper portion 207. In one embodiment, the lower portion 205 of the interior volume 206 may be smaller than an upper portion 207 of the interior volume 206 in order to reduce the quantity of liquid 210 disposed in the vessel 200, thereby reducing the quantity of energy required to be utilized to boil the liquid 210. For example, a side wall 224 of the interior volume 206 of the vessel 200 may be tapered (not shown) towards the lower portion of the vessel 200. Alternatively or in combination, an insert (not shown) may be placed within the vessel 200 to reduce the interior volume proximate the lower portion.

**The liquid** 210 partially fills the vessel 200 (*i.e.*, the liquid 210 is disposed within the lower portion 205 of the interior volume 206 of the vessel 200). The liquid 210 may be selected based upon characteristics such as boiling point, viscosity, material compatibility, vapor pressure-temperature characteristics, and the like. For example, to perform low temperature processes, *e.g*., those having a set point temperature below about 100°C, the liquid 210 may be selected to have a low boiling point. Similarly, for performing high temperature processes, e.g., those having a set point temperature greater than or equal to about 400°C, the liquid 210 may be selected to have a high boiling point. Examples of suitable liquids include, without limitation, water (100°C boiling point), mercury (357°C boiling point), silver (2210°C boiling point), commercially available liquid mixtures having high boiling points such as perfluorocarbon oils (100°C - 220°C boiling point), biphenyl-biphenyl oxide mixtures ( 215°C - 400°C boiling point), and the like. In general, substances having a normal boiling point near the desired process set point temperature and which remain stable at the temperature used can be employed.

The liquid 210 sufficiently fills the interior volume 206 of the vessel 200 such that when the liquid 210 is boiled, a portion of the liquid 210 vaporizes and creates a thin layer of condensate 226 on an inner surface 214 of the upper member 204 of the vessel 200. The condensate 226 generally completely covers the inner surface 214, thereby at least partially defining a controlled temperature buffer zone that provides uniform heat transfer to the upper member 204 and substrate 106 disposed thereupon. In addition, the interior volume 206 of the vessel 200 is typically sized such that, during operation, particles of the liquid 210 ejected from the lower portion 205 of the interior volume 206 do not contact the inner surface 214 of the upper member 204.

The inner surface 214 may be generally have any surface finish, either smooth or rough. In embodiments where a smooth surface is provided, i.e., having a surface roughness less than about 0.1 mm, the horizontal position of the inner surface 214 may be controlled to minimize non-uniform distribution of condensate on the inner surface 214. Optionally, the inner surface 214 may have an increased surface area, such as by being roughened, made porous, or the like, thereby ensuring complete coverage of the inner surface 214 with the condensate 226. Generally, the scale of the surface roughness should range between about 0.1 mm to about 5.0 mm. Optionally, the inner surface 214 may have a varying roughness and or porosity to vary the quantity of condensate 226 formed in a plurality of zones (not shown) of the upper member 204, thereby controlling the respective rates of heat flux through the plurality of zones. Optionally, the increased surface area may be varied across the inner surface 214, thereby controlling the amount of heat transfer through any specific region or zone of the upper member 204 of the substrate heater 108. Alternatively, zones of varying heat flux may be provided by increasing or decreasing the heat rate through the upper member 204, for example, by fabricating the upper member from varying materials, varying thickness profiles of the upper member, combinations of the above, and the like.

The upper portion 207 of the interior volume 206 is filled with a gas 222. The gas 222 may be any non-reactive gas which remains non-reactive throughout the entire heating process. Some factors to consider in selecting the gas 222 are condensation point, compressibility, and atomic stability. Examples of suitable gases include any one or combination of an inert gas (such as helium (He), argon (Ar), neon (Ne), krypton (Kr), xenon (Xe), and the like), nitrogen, air, and the like. In one embodiment, the gas 222 is air.

The heat source 208 is used to heat the liquid 210 to its boiling temperature in order to vaporize a portion of the liquid 210 and cause a film of condensate 226 to form on the upper member 204, thereby heating the substrate 106. The heat source 208 may be disposed within the interior volume 206 of the vessel 200 or may be disposed outside of the vessel 200. Alternatively, the heat source 208 may be formed within the body 202 of the vessel 200. The heat source 208 may comprise any suitable heat source, such as resistive heaters, radiation receivers, heat lamps, and the like. In one embodiment, the heat source 208 is configured to heat a bottom surface 212 of the vessel 200. In one embodiment, the heat source 208 is configured to provide substantially uniform heat to the liquid 210, thereby providing a uniform boil throughout the liquid 210.

In operation, the heat source 208 heats the liquid 210 to cause the liquid 210 to boil. As the liquid 210 boils inside the vessel 200, a portion of the liquid 210 is converted to a vapor, which rises in the interior volume 206 and condenses to form a thin layer of condensate 226 on the inner surface 214 of the upper member 204. As the vapor condenses on the inner surface 214, the heat from the liquid 210 is conducted through the upper member 204 of the vessel 200 to the substrate 106 disposed thereupon. Heating or cooling of the upper member 204 due to the process being performed in the chamber will be compensated for by increased evaporation or condensation of fluid on the inner surface 214 of the upper member 204.

Optionally, the vessel 200 may further include a pressure valve 216. The pressure valve 216 may be configured to allow excess gas 222 to escape from the vessel 200, thereby preventing the buildup of pressure in the vessel 200 beyond a desired level. Optionally, a pressure control unit 218 may be provided alone or in combination with the pressure valve 216. The pressure control unit 218 may be utilized to control the pressure inside the vessel 200, thereby controlling the temperature at which the liquid 210 inside the vessel 200 will boil, and, thereby advantageously controlling the temperature of the condensate formed on the upper member 204 and ultimately transferred to the substrate 106. For example, if a high boiling temperature is desired the pressure may be increased sufficiently to raise the boiling point of the liquid 210 to achieve that boiling temperature. In addition, the pressure control unit 218 may be used to maintain the pressure level in the vessel 200 at a desired level. The pressure control unit 218 may optionally be connected to a chilled recovery vessel (not shown) to recover and later reuse the liquid 210, as well as prevent its release to the environment.

Optionally, the vessel 200 may also include lift pins (not shown) to selectively position the substrate 106 with respect to the surface 204. For example, the lift pins may hold the substrate 106 away from the heated surface 204 and gradually lower the substrate 106 onto the heated surface 204 to control the rate of heating of the substrate 106 up to the set point temperature. To provide more uniform heating of the substrate 106, the heated surface 204 may optionally incorporate a vacuum chuck (not shown) or an electrostatic chuck (not shown) to provide a more reproducible junction or gap thermal resistance. Optionally, a second vapor-liquid heated disk-like surface may be positioned above the substrate 106 and piped to the upper part 207 of the vessel 200.

Optionally, an energy-phase controller 220 may be coupled to the heater 108 to control the temperature of the vessel 200 as desired. The energy-phase controller 220 may be a computer or other controller configured to control either one or both of the heat source 208 and pressure control unit 218 to control the boiling point of the liquid 210 inside the vessel 200. In one embodiment, the energy-phase controller 220 may be part of the controller 112 of the process chamber 100. Alternatively, the energy-phase controller 220 may be separate from the controller 112.

Figure 3 depicts a flow diagram of a method of heating a substrate 106 according to one embodiment of the present invention. The method 300 begins at step 302 wherein a substrate 106 is placed on a support surface 205 of a substrate heater having a liquid disposed therein, such as the substrate heater 108 described above with respect to Figures 1 and 2.

Next, at step 304, the liquid 210 inside the substrate heater 108 (*e.g.,* inside the vessel 200) is boiled to vaporize a portion of the liquid and form a layer of condensate on a bottom side of the support surface (e.g., the layer of condensate 226 described in Figure 2). The liquid 210 may be boiled by applying heat to the bottom surface 212 of the vessel 200 via a heat source 208 or other high energy source As the boiling liquid 210 evaporates, the heated vapor from the liquid 210 condenses on the inner surface 214 of the substrate support surface 204 within the vessel 200 to create a layer of condensate 226. The condensate 226 substantially uniformly covers the inner surface 214, thereby facilitating a controlled temperature buffer zone between the substrate support surface 204 and the liquid 210 and gas 222 contained inside the vessel 200 that shields the substrate support surface 204 from thermal inconsistencies which could be caused by temperature discrepancies in the liquid 210 and gas 222. Thus, a substantially uniform temperature profile may be obtained along the upper member 204 of the vessel, thereby advantageously providing substantially uniform heating to a substrate disposed on the substrate heater.

As discussed above with respect to Figure 2, the inner surface 214 of the upper member 204 may have an increased surface area, such as by a roughened and/or porous surface. The increased surface area provides more area for condensation to adhere to the inner surface 214, thereby advantageously providing substantially uniform coverage of the inner surface 214. Optionally, the increased surface area may be varied across the inner surface 214, thereby controlling the amount of heat transfer through any specific region or zone of the upper member 204 of the substrate heater 108. Alternatively, zones of varying heat flux may be provided by increasing or decreasing the heat rate through the upper member 204, for example, by fabricating the upper member from varying materials, varying thickness profiles of the upper member, combinations of the above, and the like.

Optionally, at step 306, the boiling point of the liquid 210 may be controlled by adjusting the pressure inside the vessel 200 to achieve a desirable boiling temperature (*i.e.,* to control the liquid-gas phase equilibrium temperature). For example, utilizing an energy-phase controller 220, which monitors and controls temperature and pressure within the vessel 200, the temperature of the liquid 210 may be held at a desired level while the pressure within the vessel 200 is decreased until the liquid 210 begins to boil. Thus, the boiling temperature of the liquid 210 and the resulting temperature of the layer of condensate 226 may be advantageously controlled within a broad temperature range without changing the liquid 210.

Thus, embodiments of a substrate heater and methods of heating a substrate have been provided herein. The substrate heater and methods advantageously provide for controlled heating of a substrate. The substrate heater and methods may advantageously be utilized to heat a substrate to a substantially uniform temperature, at substantially uniform rates of heating, or to heat a substrate in multiple zones.

In the following, further embodiments are described:
1. A method of heating a substrate comprising: placing a substrate on a support member of a substrate heater comprising a vessel partially filled with a liquid ; and boiling the liquid to create a film of condensation on a bottom side of the support member.
2. The method of embodiment 1, further comprising: controlling the pressure inside the vessel.
3. The method of embodiment 2, wherein the pressure is maintained at a constant pressure.
4. The method of embodiment 2 or 3, further comprising: controlling the boiling point of the liquid .
5. The method of any one of embodiments 2 to 4, wherein the step of controlling the pressure further comprises: controlling the pressure within the vessel using a pressure controller.
6. The method of embodiment 5, further comprising: selectively opening or closing a pressure valve coupled to the vessel .
7. The method of any one of the preceding embodiments, further comprising: controlling the energy phase of the liquid disposed within the vessel .
8. The method of any one of the preceding embodiments, wherein the step of boiling further comprises: providing heat to the liquid via a heat source.
9. The method of embodiment 8, wherein the heat source comprises at least one of a resistive heater, a radiation receiver, or a heat lamp.
10. The method of any one of the preceding embodiments, wherein the liquid comprises at least one of water, mercury, a perfluorocarbon oil, an aromatic hydrocarbon oil, a biphenyl-biphenyl oxide oil mixture, or silver.
11. The method of any one of the preceding embodiments, wherein the vessel comprises at least one of copper, aluminum, or ceramic.
12. The method of any one of the preceding embodiments, wherein the bottom side of the support member has a surface roughness between about 0.1 mm to about 5mm..
13. The method of any one of the preceding embodiments, wherein the bottom side of the support member is porous.
14. The method of any one of the preceding embodiments, wherein the support member further comprises zones of varying heat transfer rates.
15. The method of embodiment 14, wherein the zones of varying heat transfer rates are defined by at least one of zones of varying roughness or zones of varying porosity of the bottom surface of the support member.
16. The heater of embodiment 14 or 15, wherein the zones of varying heat transfer rates are defined by zones of varying thickness profiles of the support member.
17. The heater of any one of embodiments 14 to 16, wherein the zones of varying heat transfer rates are defined by zones of varying materials comprising the support member.
18. The method of any one of the preceding embodiments, wherein a gas is disposed within the vessel .
19. The method of embodiment 18, wherein the gas is at least one of helium, argon, neon, krypton, xenon, nitrogen, or air.

While the foregoing is directed to embodiments of the present invention, other and further embodiments of the invention may be devised without departing from the basic scope thereof, and the scope thereof is determined by the claims that follow.

## Claims

1. A substrate (106) heater (108) comprising:
a vessel (200) having an upper member (204) including a top surface for supporting a substrate (106) thereon;
a liquid (210) disposed within and partially filling the vessel (200); and
a heat source (208) for providing sufficient heat to the liquid (210) to boil the liquid.

2. The heater of claim 1, wherein the vessel (200) comprises at least one of copper, aluminum, or ceramic.

3. The heater of claim 1 or 2, wherein the liquid (210) comprises at least one of water, mercury, a perfluorocarbon oil, an aromatic hydrocarbon oil, a biphenyl-biphenyl oxide oil mixture, or silver.

4. The heater of any one of the preceding claims, wherein the heat source (208) comprises at least one of a resistive heater, a radiation receiver, and a heat lamp.

5. The heater of any one of the preceding claims, wherein the upper member (204) further comprises an interior surface (214) opposing the top surface and substantially parallel thereto, the interior surface (214) configured to collect condensate (226) from the liquid (210) during processing.

6. The heater of claim 5, wherein the interior surface (214) of the upper member (204) has a surface roughness between about 0.1 mm to about 5mm.

7. The heater of claim 5 or 6, wherein the interior surface (214) of the upper member (204) is porous.

8. The heater of any one of claims 5 to 7, wherein the upper member (204) further comprises zones of varying heat transfer rates.

9. The heater of claim 8, wherein the zones of varying heat transfer rates are defined by at least one of zones of varying roughness or zones of varying porosity of the interior surface (214) of the upper member (204).

10. The heater of claim 8 or 9, wherein the zones of varying heat transfer rates are defined by zones of varying thickness profiles of the upper member (204) zones of varying materials comprising the upper member (204).

11. The heater of any one of the preceding claims, further comprising:
at least one of a pressure controller for regulating the pressure within the vessel (200) or a pressure valve coupled to the vessel (200).

12. The heater of any one of the preceding claims, further comprising:
an energy phase controller (220) for controlling the energy-phase of the fluid (210) disposed within the vessel (200).

13. The heater of any one of the preceding claims, further comprising:
a gas disposed in the vessel (200).

14. The heater of claim 13, wherein the gas comprises at least one of helium, argon, neon, krypton, xenon, nitrogen, or air.

15. A system for heating a substrate (106) comprising:
a vessel (200) having a support surface for supporting a substrate (106) thereon;
a fluid (210) disposed within the vessel (200) at a temperature below its critical point;
an energy phase controller (220) for controlling the energy phase of the fluid (210) disposed within the vessel (200); and
a controlled temperature buffer zone for conducting heat through the vessel (200) to the support surface, the controlled temperature buffer zone partially defined by an inner surface (214) of the support surface facing an interior (206) of the vessel (200), wherein, the fluid (210) changes energy phase upon entering and leaving the controlled temperature buffer zone.

16. The system of claim 15, wherein the energy phase of the fluid (210) changes from gas to liquid (210) upon entering the controlled temperature buffer zone.

17. The system of claim 15 or 16, wherein the energy-phase controller (220) controls at least one of the temperature or pressure within the vessel (200).

18. The system of any one of claims 15 to 17, wherein the fluid (210) comprises at least one of water, mercury, a perfluorocarbon oil, an aromatic hydrocarbon oil, a biphenyl-biphenyl oxide oil mixture, or silver.

19. The system of claim 18, further comprising:
a gas disposed within the vessel (200).

20. The system of any one of claims 15 to 19, further comprising a heat source (208) configured to provide heat to the fluid (210).

21. The system of any one of claims 15 to 20, wherein the support surface further comprises lift pins.

22. The system of any one of claims 15 to 21, further comprising at least one of a vacuum chuck or an electrostatic chuck disposed beneath the support surface.

23. The system of any one of claims 15 to 22, comprising a heater of any one of claims 1 to 14.
